# EUROPÄISCHE PATENTSCHRIFT

(11) **EP 0 884 772 B1**
(45) Veröffentlichungstag und Bekanntmachung des Hinweises auf die Patenterteilung: **07.08.2002**
(21) Anmeldenummer: 98108752.1
(22) Anmeldetag: 14.05.1998
(51) Int. Cl.: H01L 21/306

(54) **Verfahren zum Ätzen von Halbleiterscheiben**
Process for etching silicon wafers
Procédé d'attaque de plaquettes de silicium

(30) Priorität: 22.05.1997 DE 19721493
(43) Veröffentlichungstag der Anmeldung: 16.12.1998
(73) Patentinhaber: Wacker Siltronic Gesellschaft für Halbleitermaterialien Aktiengesellschaft, 84489 Burghausen (DE)
(72) Erfinder: Bauer, Theresia, Dr., 84508 Burgkirchen (DE); Weizbauer, Susanne, Dr., 83024 Rosenheim (DE); Wochner, Hanns, Dr., 84489 Burghausen (DE); Bergler, Alfred, 84524 Neuötting (DE)

(56) Entgegenhaltungen:
- EP-A- 0 791 953
- US-A- 3 966 517
- US-A- 4 540 465
- US-A- 5 340 437
- SCHWARTZ ET AL: "Chemical etching of silicon" JOURNAL OF THE ELECTROCHEMICAL SOCIETY., Bd. 123, Nr. 12, Dezember 1976, Seiten 1903-1909, XP002082423 MANCHESTER, NEW HAMPSHIRE US
- SCHWARTZ ET AL: "Chemical etching of Germanium in solutions of HF, HNO3, H2O and HC2H3O2" JOURNAL OF THE ELECTROCHEMICAL SOCIETY., Bd. 111, Nr. 2, Februar 1964, Seiten 196-201, XP002082424 MANCHESTER, NEW HAMPSHIRE US
- PATENT ABSTRACTS OF JAPAN vol. 1, no. 135 (E-061), 9. November 1977 & JP 52 071180 A (MITSUBISHI ELECTRIC), 14. Juni 1977

## Beschreibung

Die Erfindung betrifft ein Verfahren zum Ätzen von Halbleiterscheiben durch Einwirkung eines Ätzgemisches, das durch Mischen von Salpetersäure und Flußsäure und gegebenenfalls einer oberflächenaktiven Substanz erhalten wird.

Halbleiterscheiben, wie beispielsweise Halbleiterscheiben aus Silicium, als Basismaterial für elektronische Bauteile, erhält man aus einem stabförmigen Einkristall über eine Folge von Bearbeitungsschritten. Zunächst wird der Einkristall in Scheiben gesägt. Die oberflächennahen Kristallbereiche der resultierenden Halbleiterscheiben werden durch das Draht- oder Innenlochsägen bis in eine Tiefe von ca. 80 µm beschädigt. Dieses sog. "damage" wird in der Regel durch eine mechanische Oberflächenbehandlung beispielsweise durch Läppen oder Schleifen der Scheiben reduziert.
Naßchemisches Abtragen weiterer Siliciumschichten führt dann zur nahezu vollständigen Entfernung des damage und zur bewußten Erzeugung definierter Oberflächenparameter wie Mikrorauhigkeit und Reflektivität. Ziel des Ätzens ist es, eine möglichst planparallele und defektfreie Scheibenoberfläche mit niedriger Mikrorauhigkeit und hoher Reflektivität zu erhalten. Führt man den Ätzprozeß im sauren Medium durch, so werden häufig Salpetersäure als oxidierendes und Fluorwasserstoff als auflösendes Agens, gegebenenfalls in Verbindung mit einer oberflächenaktiven Substanz eingesetzt. Ein derartiges Verfahren ist beispielsweise in der US-5,451,267 beschrieben.

Beim Einsatz der genannten Säuren ist zu beachten, daß ihre Entsorgung umweltverträglich sein muß und daher erhebliche Kosten verursacht. Es bestand daher die Aufgabe, nach Wegen zu suchen, wie der Säureverbrauch reduziert werden kann, ohne daß dabei eine Verschlechterung des Ätzergebnisses in Kauf genommen werden muß.

Der Druckschrift "Journal of the Electrochemical Society", Band 123, Nammer 12, Seiten 1903-1909 offenbart ein Verfahren zum Ätzen von Silizium mit einer Mischung von Salpetersäure mit einer Konzentration von 90% und Flußsäure mit einer Konzentration von 60%.

Gelöst wird die Aufgabe durch ein Verfahren zum Ätzen von Halbleiterscheiben mit einem Ätzgemisch, das durch Mischen von Salpetersäure und Flußsäure und gegebenenfalls einer oberflächenaktiven Substanz erhalten wird und zu dem entweder Flußsäure oder Flußsäure und Salpetersäure nachdosiert wird, das dadurch gekennzeichnet ist, daß
zum Mischen des Ätzgemisches Salpetersäure mit einer Konzentration von ≥70 Gew.-% und Flußsäure mit einer Konzentration von ≥ 70 Gew.-%.

Durch die Verwendung eines Ätzgemisches, das wenigstens eine der zum Einsatz kommenden Säuren in einer konzentrierteren Form enthält, als es bisher üblich war, ist es möglich, die Badstandzeit beim Ätzen erheblich zu verlängern. Dies bedeutet, daß wesentlich mehr Halbleiterscheiben geätzt werden können, bevor das Ätzgemisch ausgewechselt und entsorgt werden muß. Dadurch können Säuren eingespart werden und die mit dem Ätzen verbundenen Kosten sinken, obwohl die Aufwendungen für Sicherheit in Abhängigkeit der Säurekonzentration steigen.

Unter dem Begriff Badstandzeit ist die Zeitspanne zu verstehen, während der das Ätzgemisch zum Ätzen von Halbleiterscheiben verwendet werden kann. Dies ist solange der Fall, solange die Mikrorauhigkeit und die Reflektivität der geätzten Halbleiterscheiben in einem gewünschten Toleranzbereich liegen, und die Verunreinigung des Ätzgemisches mit Metallen, Partikeln und Hexafluorokieselsäure einen vorbestimmten Wert nicht überschreitet.

Eine Verlängerung der Badstandzeiten ist insbesondere möglich, wenn zum Mischen des Ätzgemisches Salpetersäure mit einer Konzentration von 73 bis 98 Gew.-% und Flußsäure mit einer Konzentration von >70 bis 95 Gew.-% eingesetzt wird.

Es hat sich darüber hinaus herausgestellt, daß die Werte für Mikrorauhigkeit und Reflektivität bei den geätzten Halbleiterscheiben von der Konzentration der zum Mischen des Ätzgemisches eingesetzten Salpetersäure abhängen. Sie sind umso günstiger, je konzentrierter die eingesetzte Salpetersäure ist. Dennoch werden auch bei Verwendung eines Ätzgemisches, das Salpetersäure enthält, die im Umfang des oben angegebenen Bereichs relativ niedrig konzentriert ist, Halbleiterscheiben mit ausreichenden Rauhigkeits- und Glanzwerten erhalten. Der Einsatz einer möglichst konzentrierten Salpetersäure beim Mischen des Ätzgemisches kann daher auch genutzt werden, um den Materialabtrag pro Halbleiterscheibe zu verringern, ohne daß sich dadurch die Werte für Mikrorauhigkeit und Reflektivität der Halbleiterscheiben gegenüber dem Gewohnten verschlechtern. In der Summe ist damit eine beträchtliche Einsparung von Halbleitermaterial möglich. Besonders bevorzugt ist die Verwendung eines Ätzgemisches, das durch Mischen von Salpetersäure mit einer Konzentration von 80 Gew.-% und und Flußsäure mit einer Konzentration von 70 Gew.-% erhalten wird. Mit diesem Ätzgemisch können Halbleiterscheiben erhalten werden, deren Werte für Mikrorauhigkeit und Reflektivität denen entsprechen, zu deren Erreichen mit üblichen Verfahren ein um ein Drittel höherer Materialabtrag notwendig ist. Ähnlich gute Ergebnisse bzgl. der Verlängerung der Badstandzeit, nicht aber bzgl. der Siliciumeinsparung, werden mit einem Ätzgemisch erzielt, das durch Mischen von Salpetersäure mit einer Konzentration von 70 Gew.-% und Flußsäure mit einer Konzentration von 85 Gew.-% erhalten wird.

Zur weiteren Verbesserung des Ätzens wird vorgeschlagen, entweder Flußsäure oder Salpetersäure und Flußsäure zum Ätzgemisch nachzudosieren. Die nachdosierte Säure weist vorzugsweise die gleiche Konzentration auf, wie die entsprechende Säure, die zum Mischen des Ätzgemisches eingesetzt worden ist.

Die im Ätzgemisch eingesetzte Salpetersäure und Flußsäure kann durch das Nachdosieren und durch beim Ätzen gebildetes Wasser verdünnt werden. Es ist daher besonders bevorzugt, diesem Verdünnungseffekt dadurch zu begegnen, daß Flußsäure oder Flußsäure und Salpetersäure nachdosiert wird, und die nachdosierte Säure um 5 bis 10 % konzentrierter ist als die entsprechende Säure, die zum Mischen des Ätzgemisches eingesetzt worden ist. Die Konzentrationen der Säuren für das Ätzgemisch müssen in diesem Fall natürlich so gewählt werden, daß ein Nachdosieren mit höher konzentrierten Säuren noch möglich ist. überraschenderweise verlängert diese Maßnahme nicht nur die Badstandzeit, sondern hat auch eine positive Auswirkung auf die Werte für Mikrorauhigkeit und Reflektivität der geätzten Halbleiterscheiben. Die Streubreite dieser Werte wird enger und auch qualitativ besser. Dieser Effekt kann noch verstärkt werden, indem zusätzlich zum Nachdosieren ein bestimmtes Volumen des Ätzgemisches ausgetauscht wird.

Mit der erfindungsgemäßen Verfahrensweise erhält man bei einem vorgegebenen Oberflächenzustand der Siliciumscheiben Werte für die Reflektivität, die je nach Säurekonzentration zwischen 28 und 40 % liegen. Für die Mikrorauhigkeit Ra werden Werte zwischen 0,15 µm und 0,13 µm gemessen. Bei Ätzprozessen gemäß Stand der Technik mit gleichem Ätzabtrag aber niedrigeren Säurekonzentrationen haben die Halbleiterscheiben dagegen Reflektivitätswerte von nur 15 bis 20 % und Mikrorauhigkeiten von 0,17 µm bis 0,25 µm.

Im folgenden werden zwei Vergleichsbeispiele, in dem Siliciumscheiben mit einem Ätzgemisch gemäß Stand der Technik behandelt wurden, einem Beispiel der erfindungsgemäßen Behandlung von Halbleiterscheiben gegenübergestellt.

Die Reflektivität der geätzten Oberflächen wurde mit einem Reflektometer bestimmt, wobei eine polierte Siliciumscheibe mit einer Reflektivität von 100 % als Referenz diente. Die Mikrorauhigkeit Ra wurde mit einem Perthometer (0,8 µm Filter, 4,8 µm Meßstrecke) gemessen. Die Messungen erfolgten an jeweils drei Punkten entlang der Scheibenhorizontalen, wobei der Meßwert den Mittelwert aus fünf Scheiben darstellt.

Je fünf Halbleiterscheiben wurden drei verschiedenen Ätzprozessen unterworfen. Dabei wurde der Ätzabtrag, die Konzentration der Salpetersäure und der Flußsäure variiert; die Menge an zugesetzter oberflächenaktiven Substanz sowie sämtliche anderen Prozeßparameter (Temperatur, Zeit etc.) wurden konstant gehalten. Die Ergebnisse sind in Tabelle 1 zusammengefaßt.

Die Meßwerte zeigen, daß eine Steigerung der Reflektivität und Erniedrigung der Mikrorauhigkeit entweder durch Erhöhung des Ätzabtrags (vgl. Vergleichsbeispiel 1 mit Vergleichsbeispiel 2) oder, erfindungsgemäß, durch Verwendung höher konzentrierter Säuren bzw. eines höher konzentrierten Säuregemisches erzielt werden kann (vgl. Vergleichsbeispiel 2 mit Beispiel 3). Mit dem Verfahren gemäß Stand der Technik ist dieses Ergebnis nur mittels erhöhten Ätzabtrags zu erhalten. Dies sollte aber wegen des damit verbundenen Verlustes an Reinstsilicium und erhöhten Säureverbrauchs vermieden werden. Der Vergleich der Meßwerte von Vergleichsbeispiel 2 mit Beispiel 3 zeigt eine deutliche Verbesserung der Reflektivität und Mikrorauhigkeit bei der erfindungsgemäßen Behandlung der Siliciumscheiben.

**Tabelle 1:**

| Reflektivität und Mikrorauhigkeit bei Variation des Ätzprozesses | | | |
|---|---|---|---|
| | Vergleichsbeispiel 1 | Vergleichsbeispiel 2 | Beispiel 3 |
| Konzentration HNO₃ zum Mischen des Ätzgemisches [Gew.-%] | 70 | 70 | 80 |
| Konzentration HF zum Mischen des Ätzgemisches [Gew.-%] | 50 | 50 | 70 |
| Ätzabtrag z [µm] | 30 | 20 | 20 |
| Reflektivität [%] | 38 | 18 | 37 |
| Mikrorauhigkeit Ra [µm] | 0,14 | 0,16 | 0,14 |

Durch Verwendung der hochkonzentrierten Ätzgemische können, bedingt durch den dadurch möglich werdenden geringeren Ätzabtrag, die Badstandzeiten bei gleichbleibend hoher Oberflächenqualität erheblich verlängert werden. Je nachdem wie hoch die Konzentrationen gewählt wird, kann die Badstandzeit um den Faktor zwei bis drei verlängert und der Siliciumabtrag um ein Drittel reduziert werden. Daraus ergibt sich ein großes Einsparpotential an Reinstsilicium und eine deutliche Reduzierung der Umweltbelastung durch den geringeren Säureverbrauch.

Tabelle 2 zeigt Beispiele (B1-B4, B7 und B8) der erfindungsgemäßen Behandlung von Halbleiterscheiben mit verschiedenen Säurekonzentrationen. Als Vergleichsbeispiel (V) diente ein Ätzprozeß gemäß Stand der Technik, bei dem Salpetersäure mit einer Konzentration von 70 Gew.-% und Flußsäure mit einer Konzentration von 50 Gew.-% zu einem Ätzgemisch gemischt wurden.
Die Nachdosierung erfolgte entsprechend dem stöchiometrischen Verbrauch an Säuren und der Menge, die beim Herausheben der Halbleiterscheiben aus dem Ätzbad verloren gehen.

**Tabelle 2:**

| Verlängerung der Badstandzeit beim Einsatz hochkonzentrierter Säuren | | | | | |
|---|---|---|---|---|---|
| | Koriz. * HNO₃ [Gew.%] | Konz. * HF [Gew.%] | Koriz. HNO₃ * Nachdosierung [Gew.%] | Koriz. HF * Nachdosierung [Gew.%] | Faktor für Verlängerung der Badstandzeit |
| V | 70 | 50 | 70 | 50 | 1 |
| B1 | 70 | 70 | 70 | 70 | 1,6 |
| B2 | 70 | 85 | 70 | 85 | 2 |
| B3 | 70 | 100 | 70 | 100 | 2,5 |
| B4 | 75 | 70 | 75 | 70 | 2,4 |
| B5 | 85 | 50 | 85 | 50 | 2,4 |
| B6 | 85 | 60 | 85 | 60 | 2,8 |
| B7 | 85 | 70 | 85 | 70 | 3,9 |
| B8 | 80 | 70 | 80 | 70 | 3,1 |

| | | | | | |
|---|---|---|---|---|---|
| * als Einzelkomponente | | | | | |

Wie aus Tabelle 1 und Tabelle 2 deutlich wird, sind mit dem erfindungsgemäßen Verfahren verlängerte Badstandzeiten und verbesserte Oberflächeneigenschaften bei gleichzeitig geringerem Ätzabtrag zu erzielen.

## Patentansprüche

1. Verfahren zum Ätzen von Halbleiterscheiben mit einem Ätzgemisch wobei die Halbleiterscheiben in einem Ätzgemisch eingetaucht werden, das durch Mischen von Salpetersäure und Flußsäure und gegebenenfalls einer oberflächenaktiven Substanz erhalten wird und zu dem entweder Flußsäure oder Flußsäure und Salpetersäure nachdosiert wird, **dadurch gekennzeichnet, daß**
zum Mischen des Ätzgemisches Salpetersäure mit einer Konzentration von ≥70 Gew.-% und Flußsäure mit einer Konzentration von ≥70 Gew.-% eingesetzt wird.

2. Verfahren nach Anspruch 1, **dadurch gekennzeichnet, daß** zum Mischen des Ätzgemisches Salpetersäure mit einer Konzentration von 73 bis 98 Gew.-% und Flußsäure mit einer Konzentration von >70 bis 95 Gew.-% eingesetzt wird.

3. Verfahren nach Anspruch 1 oder Anspruch 2, **dadurch gekennzeichnet, daß** Flußsäure oder Flußsäure und Salpetersäure nachdosiert wird, und die nachdosierte Säure die gleiche Konzentration aufweist, wie die entsprechende Säure, die zum Mischen des Ätzgemisches eingesetzt wurde.

4. Verfahren nach Anspruch 1 oder Anspruch 2, **dadurch gekennzeichnet, daß** Flußsäure oder Flußsäure und Salpetersäure nachdosiert wird, und die nachdosierte Säure um 5 bis 10 % konzentrierter ist, wie die entsprechende Säure, die zum Mischen des Ätzgemisches eingesetzt wurde.

5. Verfahren nach einem der Ansprüche 1 bis 4, **dadurch gekennzeichnet, daß** zusätzlich zum Nachdosieren ein bestimmtes Volumen des Ätzgemisches ausgetauscht wird.

## Claims

1. Process for etching semiconductor wafers with an etching mixture by dipping the semiconductor wafers in an etching mixture which is obtained by mixing nitric acid and hydrofluoric acid and optionally a surfactant and to which either further hydrofluoric acid or further hydrofluoric acid and nitric acid is/are added, **characterized in that** nitric acid having a concentration of ≥ 70% by weight and hydrofluoric acid having a concentration of ≥ 70% by weight are used to prepare the etching mixture.

2. Process according to Claim 1, **characterized in that** nitric acid having a concentration of 73 to 98% by weight and hydrofluoric acid having a concentration of > 70 to 95% by weight are used to prepare the etching mixture.

3. Process according to Claim 1 or 2, **characterized in that** further hydrofluoric acid or further hydrofluoric acid and nitric acid is/are added and the further acid added has the same concentration as the corresponding acid which was used to prepare the etching mixture.

4. Process according to Claim 1 or 2, **characterized in that** further hydrofluoric acid or further hydrofluoric acid and nitric acid is/are added and the further acid added is 5 to 10% more concentrated than the corresponding acid which was used to prepare the etching mixture.

5. Process according to any of Claims 1 to 4, **characterized in that** a certain volume of the etching mixture is replaced in addition to the further addition.

## Revendications

1. Procédé d'attaque chimique de plaquettes de semiconducteurs avec un mélange d'attaque chimique, dans lequel les plaquettes de semiconducteurs sont immergées dans un mélange d'attaque chimique qui est obtenu en mélangeant de l'acide nitrique et de l'acide fluorhydrique et éventuellement une substance tensioactive et auquel on ajoute ultérieurement en quantité mesurée, soit de l'acide fluorhydrique soit de l'acide fluorhydrique et de l'acide nitrique, **caractérisé en ce que**
de l'acide nitrique ayant une concentration ≥ 70 % en poids et de l'acide fluorhydrique ayant une concentration ≥ 70 % en poids sont utilisés pour préparer le mélange d'attache chimique.

2. Procédé selon la revendication 1, **caractérisé en ce que** de l'acide nitrique ayant une concentration de 73 à 98 % en poids et de l'acide fluorhydrique ayant une concentration > 70 à 95 % en poids sont utilisés pour préparer le mélange d'attache chimique.

3. Procédé selon la revendication 1 ou la revendication 2, **caractérisé en ce que** l'acide fluorhydrique ou l'acide fluorhydrique et l'acide nitrique sont ajoutés ultérieurement en quantité mesurée, et l'acide ajouté ultérieurement en quantité mesurée présente la même concentration que l'acide correspondant qui a été utilisé pour préparer le mélange d'attaque chimique.

4. Procédé selon la revendication 1 ou la revendication 2, **caractérisé en ce que** l'acide fluorhydrique ou l'acide fluorhydrique et l'acide nitrique sont ajoutés ultérieurement en quantité mesurée et l'acide ajouté ultérieurement en quantité mesurée est de 5 à 10 % plus concentré que l'acide correspondant qui a été utilisé pour préparer le mélange d'attaque chimique.

5. Procédé selon l'une quelconque des revendications 1 à 4, **caractérisé en ce qu'**en plus de l'addition ultérieure en quantité mesurée, un volume déterminé du mélange d'attaque chimique est remplacé.
